# FASCICULE DE BREVET EUROPEEN

(11) **EP 4 701 374 B1**
(45) Date de publication et mention de la délivrance du brevet: **12.08.2026**
(21) Numéro de dépôt: 25196327.8
(22) Date de dépôt: 18.08.2025
(51) Int. Cl.: H10F 71/00, B23K 26/08

(54) **DISPOSITIF D'INTERCONNEXION DE CELLULES PHOTOVOLTAÏQUES**
VORRICHTUNG ZUR VERBINDUNG VON PHOTOVOLTAISCHEN ZELLEN
DEVICE FOR INTERCONNECTING PHOTOVOLTAIC CELLS

(30) Priorité: 19.08.2024 FR 2408964
(43) Date de publication de la demande: 25.02.2026
(73) Titulaire: Commissariat à l'Energie Atomique et aux Energies Alternatives, 75015 Paris (FR)
(72) Inventeur: BARTH, Vincent, 38054 GRENOBLE CEDEX 09 (FR); JERONIMO, Pedro, 38054 GRENOBLE CEDEX 09 (FR)
(74) Mandataire: Regimbeau

(56) Documents cités:
- CN-A- 103 692 086
- CN-U- 220 445 359

## Description

### DOMAINE TECHNIQUE DE L'INVENTION

La présente invention se rapporte au domaine général des modules photovoltaïques, qui comportent un ensemble de cellules photovoltaïques reliées entre elles électriquement, et préférentiellement des cellules photovoltaïques dites « cristallines », c'est-à-dire qui sont à base de silicium monocristallin ou multicristallin, de matériaux III-V, de couches minces (CIGS, CdTe, pérovskites, etc.) ou toute combinaison de ces différents matériaux.

En particulier, elle concerne les cellules photovoltaïques de type tandem combinant le silicium et un matériau pérovskite, les cellules photovoltaïques homojonction ou hétérojonction à base de silicium monocristallin (c-Si) et/ou multi-cristallin (mc-Si), , les cellules photovoltaïques comprenant au moins un matériau parmi le silicium amorphe (a-Si), le silicium microcristallin (µC-Si), le tellurure de cadmium (CdTe), le cuivre-indium séléniure (CIS), le cuivre-indium/gallium diséléniure (CIGS), et les pérovskites, entre autres.

Plus précisément, l'invention se rapporte au domaine de l'interconnexion des cellules photovoltaïques qui permet la formation de chaînes ou séries (ou encore « strings » en anglais) de cellules photovoltaïques, et elle concerne en particulier les équipements et procédés mis en œuvre lors de la soudure réalisée pour l'interconnexion.

Elle concerne ainsi le domaine des modules photovoltaïques utilisés pour des applications spatiales mais aussi pour des applications terrestres, et également pour des applications de type mobilité électronique, ballons ou drones, entre autres. De manière plus générale, l'invention s'applique aux applications photovoltaïques pour lesquelles la problématique d'interconnexion de cellules photovoltaïques est pertinente.

L'invention concerne ainsi un dispositif d'interconnexion de cellules photovoltaïques, ainsi qu'un procédé d'interconnexion de cellules photovoltaïques mis en œuvre au moyen d'un tel dispositif.

### ÉTAT DE LA TECHNIQUE

Un module photovoltaïque terrestre est classiquement constitué de cellules photovoltaïques électriquement connectées entre elles, généralement en série, et encapsulées dans un empilement de matériaux de type polymère et/ou verre. Cet empilement permet de protéger les cellules photovoltaïques de l'environnement extérieur, comme par exemple de la pluie, du vent, de la neige, de l'humidité, des rayonnements ultraviolets, des radiations, des chocs thermiques, entre autres, tout en conservant la fonction de conversion photoélectrique.

Ainsi, classiquement, un module photovoltaïque terrestre forme un empilement comportant successivement: un élément de protection arrière appelé « backsheet » en anglais, transparent ou non, comme par exemple une plaque de verre ou un film polymère ; un premier film encapsulant polymère ; des cellules photovoltaïques reliées électriquement entre elles, typiquement par des interconnecteurs, le plus souvent des rubans de cuivre étamé ; un deuxième film encapsulant polymère ; un élément de protection avant appelé « frontsheet » en anglais, transparent, comme par exemple une plaque de verre ou un film polymère.

L'élément de protection avant est destiné à transmettre le rayonnement solaire aux cellules photovoltaïques pour générer de l'électricité, tout en les protégeant des contraintes de l'environnement. Cet empilement est ensuite solidarisé lors d'une étape de lamination à chaud, typiquement entre 100 et 150°C, pour faire fondre les films encapsulant et provoquer la réticulation des polymères, d'où il résulte la formation d'une enveloppe d'encapsulation solide des cellules photovoltaïques collée aux éléments de protection avant et arrière.

L'interconnexion des cellules photovoltaïques est nécessaire pour pouvoir extraire le courant électrique généré par les cellules en limitant la résistance. Elle doit être résiliente pour conserver les performances et éviter les incidents potentiellement catastrophiques, comme les incendies. L'article « A review of interconnection technologies for improved crystalline silicon solar cell photovoltaic module assembly », Musa T. Zarmai et al., School of Engineering, Faculty of Science and Engineering, University of Wolverhampton, Applied Energy 154, 173-182, 15 septembre 2015, présente par exemple différentes approches connues d'interconnexion des cellules photovoltaïques dans le domaine du photovoltaïque terrestre.

Pour les modules photovoltaïques terrestres, les interconnecteurs sont classiquement des rubans ou fils de cuivre avec un revêtement argent (Ag) ou étain (Sn). La connexion électrique entre rubans/fils et cellules est assurée, dans la grande majorité des cas, sans fusion des métaux de base, par brasage avec un métal d'apport, ce qui permet d'obtenir de bons contacts ohmiques à des températures inférieures à 400°C. Dans un dispositif d'interconnexion mettant en œuvre le brasage pour réaliser l'interconnexion, les rubans ou fils sont généralement placés sur les faces avant et arrière des cellules photovoltaïques, puis un brasage simultané des faces avant et arrière est réalisé par chauffage pour éviter le fléchissement (ou « bowing » en anglais). Un masque de maintien des rubans/fils sur les cellules photovoltaïques peut être utilisé pour maintenir le contact des rubans/fils sur des plots métalliques, notamment des plots d'argent.

Dans le domaine spatial, l'interconnexion par brasage n'est pas recommandée. En effet, aux températures d'utilisation du spatial inférieures à -40°C, l'étain passe de sa forme β à sa forme α et ce changement s'accompagne d'une modification de volume et d'une fragilisation du matériau avec la présence de fissures (« embrittlement » en anglais). Ce phénomène est appelé « peste de l'étain ».

Une autre approche, à la fois valable pour le terrestre et le spatial, consiste à utiliser une soudure avec ou sans métal d'apport et qui implique la fusion des métaux de base, notamment l'argent, le cuivre et l'aluminium. Pour des températures basses, de l'ordre de 100°C, des colles conductrices, souvent constituées de particules métalliques, notamment d'argent, dans une matrice polymère peuvent être utilisées. Pour des températures localement élevées, par exemple supérieures à 600°C, typiquement de l'ordre de 1085°C pour le cuivre, 962°C pour l'argent et 660°C pour l'aluminium, une soudure sans apport de matière peut être effectuée. Ainsi, il peut être nécessaire d'atteindre des températures qui sont trop élevées et non compatibles avec l'utilisation de certaines catégories de cellules photovoltaïques, comme les cellules photovoltaïques à hétérojonction de silicium, qui nécessitent une température de fabrication et de traitement inférieure à 200°C ou les cellules de type tandem nécessitant une température de fabrication et de traitement inférieure à 150°C, lorsque la chauffe est globale comme dans les procédés d'interconnexion par brasage.

Il existe donc un besoin pour obtenir un apport d'énergie localisé afin d'atteindre les températures élevées requises par la soudure.

Dans le document CN 220445359U, une méthode est proposée dans laquelle un dispositif d'interconnexion par soudure laser est utilisé pour former une chaîne de cellules photovoltaïques interconnectées par des conducteurs de liaison.

L'interconnexion est critique du fait de sa fonction essentielle de transport de courant. Elle doit résister aux dilatations liées aux contraintes environnementales lors de la fabrication, notamment lors de la soudure, ou lors du fonctionnement du module photovoltaïque, par exemple lors d'éclipses au cours d'orbites terrestres, et ce malgré les différences de coefficients de dilatation thermique (ou CTE pour « Coefficient of Thermal Expansion » en anglais CTE). Ainsi, l'obtention d'une solution optimale d'échauffement localisé devrait permettre de limiter les effets CTE.

### EXPOSÉ DE L'INVENTION

L'invention a pour but de remédier au moins partiellement aux besoins mentionnés ci-dessus et aux inconvénients relatifs aux réalisations de l'art antérieur.

En particulier, l'invention vise à permettre l'interconnexion de cellules photovoltaïques en maintenant une excellente conductivité ohmique entre les cellules quelques soient les déformations appliquées, mécaniques ou thermomécaniques.

Elle vise notamment à permettre l'interconnexion par soudure pour de multiples types de cellules photovoltaïques, sans contrainte de température, tout en permettant la soudure des deux côtés des cellules photovoltaïques.

L'invention a ainsi pour objet, selon l'un de ses aspects, un dispositif d'interconnexion par soudure laser de cellules photovoltaïques pour former au moins une chaîne de cellules photovoltaïques interconnectées par des conducteurs de liaison, caractérisé en ce qu'il comporte :
- une zone de dépose d'au moins une cellule photovoltaïque comprenant une ouverture traversante configurée pour exposer la face avant et la face arrière de ladite au moins une cellule photovoltaïque de part et d'autre de l'ouverture traversante lorsque ladite au moins une cellule photovoltaïque est positionnée sur la zone de dépose,
- une première unité de soudure laser comportant une première tête laser configurée pour effectuer au moins un tir laser pour la fusion locale, ou encore fusion localisée, d'au moins un conducteur de liaison positionné sur la face avant de ladite au moins une cellule photovoltaïque,
- une deuxième unité de soudure laser comportant une deuxième tête laser configurée pour effectuer au moins un tir laser pour la fusion locale, ou encore fusion localisée, d'au moins un conducteur de liaison positionné sur la face arrière de ladite au moins une cellule photovoltaïque,
les première et deuxième unités de soudure laser étant situées de part et d'autre de l'ouverture traversante.

Le dispositif d'interconnexion selon l'invention peut en outre comporter l'une ou plusieurs des caractéristiques suivantes prises isolément ou suivant toutes combinaisons techniques possibles.

Le dispositif d'interconnexion par soudure laser peut comporter un module de convoyage, notamment une courroie de convoyage, de part et d'autre de l'ouverture traversante sur lequel ladite au moins une cellule photovoltaïque est destinée à venir en appui au niveau de ses bords opposés.

De plus, le dispositif d'interconnexion par soudure laser peut comporter une unité de convoyage, notamment un convoyeur à bande ou tapis roulant, située à distance de l'ouverture traversante, sur laquelle est formée ladite au moins une chaîne de cellules photovoltaïques et sur laquelle ladite au moins une cellule photovoltaïque est destinée à être convoyée par le module de convoyage après soudure laser réalisée sur les faces avant et arrière de ladite au moins une cellule photovoltaïque, le module de convoyage étant notamment situé de part et d'autre de l'unité de convoyage.

La première unité de soudure laser peut comporter un premier masque de tir laser au travers duquel la première tête laser est apte à effectuer ledit au moins un tir laser. Le premier masque de tir laser peut être configuré pour maintenir en position ledit au moins un conducteur de liaison contre la face avant de ladite au moins une cellule photovoltaïque.

La deuxième unité de soudure laser peut comporter un deuxième masque de tir laser au travers duquel la deuxième tête laser est apte à effectuer ledit au moins un tir laser. Le deuxième masque de tir laser peut être configuré pour maintenir en position ledit au moins un conducteur de liaison contre la face arrière de ladite au moins une cellule photovoltaïque.

Le premier masque de tir laser et/ou le deuxième masque de tir laser peut être tel que celui décrit dans la revendication 1 de la demande de brevet français déposée sous le numéro FR2408965, et peut comporter une ou plusieurs des caractéristiques optionnelles définies dans les revendications dépendantes de cette demande, qui est incorporée ici par référence. Ainsi, le premier masque de tir laser et/ou le deuxième masque de tir laser peut comporter une pluralité de picots de tir laser au travers desquels au moins un tir laser est apte à être effectué pour la soudure par fusion locale d'au moins un conducteur de liaison positionné sur la face avant ou la face arrière d'au moins une cellule photovoltaïque, chaque picot de tir laser étant creux et comportant une ouverture de forme conique. L'ouverture de forme conique peut avantageusement permettre d'assurer que le tir laser atteigne correctement la zone à souder, à savoir le conducteur de liaison au contact de la cellule photovoltaïque.

La première unité de soudure laser peut comporter au moins un premier système de vision permettant de positionner la première tête laser selon une position prédéterminée. De même, la deuxième unité de soudure laser peut comporter au moins un deuxième système de vision permettant de positionner la deuxième tête laser selon une position prédéterminée.

En outre, la première tête laser de la première unité de soudure laser peut être montée en translation par rapport à un premier bâti de la première unité de soudure laser, notamment montée en translation selon un premier axe horizontal, en translation selon un deuxième axe horizontal et en translation selon un troisième axe vertical, les premier, deuxième et troisième axes étant les axes d'un repère à trois axes.

De même, la deuxième tête laser de la deuxième unité de soudure laser peut être montée en translation par rapport à un deuxième bâti de la deuxième unité de soudure laser, notamment montée en translation selon un premier axe horizontal, en translation selon un deuxième axe horizontal et en translation selon un troisième axe vertical, les premier, deuxième et troisième axes étant les axes d'un repère à trois axes.

Le dispositif d'interconnexion peut encore comporter :
- une unité d'empilement de cellules photovoltaïques,
- une unité de prise, notamment un robot de prise, de ladite au moins une cellule photovoltaïque depuis l'unité d'empilement pour son transport vers la zone de dépose.

L'unité de prise peut comporter des moyens de prise de ladite au moins une cellule photovoltaïque, notamment sous la forme de ventouses pour l'aspiration de ladite au moins une cellule photovoltaïque.

En outre, l'unité de prise peut comporter un troisième système de vision permettant de positionner les moyens de prise selon une position prédéterminée.

Le dispositif d'interconnexion peut de plus comporter une unité d'acheminement de conducteurs de liaison vers la zone de dépose.

Par ailleurs, l'invention a aussi pour objet, selon un autre de ses aspects, un procédé d'interconnexion par soudure laser de cellules photovoltaïques interconnectées par des conducteurs de liaison, mis en œuvre au moyen d'un dispositif d'interconnexion par soudure laser tel que défini précédemment.

Le procédé peut comporter les étapes suivantes :
- positionner au moins une cellule photovoltaïque sur la zone de dépose en appui de part et d'autre de l'ouverture traversante pour exposer la face avant et la face arrière de ladite au moins une cellule photovoltaïque, la face avant et la face arrière étant au contact d'au moins un conducteur de liaison,
- effectuer au moins un tir laser pour la fusion locale, ou encore fusion localisée, dudit au moins un conducteur de liaison positionné sur l'une de la face avant et de la face arrière de ladite au moins une cellule photovoltaïque par le biais de la première tête laser de la première unité de soudure laser,
- effectuer au moins un tir laser pour la fusion locale, ou encore fusion localisée, dudit au moins un conducteur de liaison positionné sur l'autre de la face avant et de la face arrière de ladite au moins une cellule photovoltaïque par le biais de la deuxième tête laser de la deuxième unité de soudure laser.

De plus, le procédé peut comporter l'étape suivante :
- déplacer ladite au moins une cellule photovoltaïque, après soudure laser, par le biais d'un module de convoyage, notamment une courroie de convoyage, situé de part et d'autre de l'ouverture traversante et sur lequel ladite au moins une cellule photovoltaïque est en appui au niveau de ses bords opposés, en direction d'une unité de convoyage, notamment un convoyeur à bande ou tapis roulant, située à distance de l'ouverture traversante, et sur laquelle est formée ladite au moins une chaîne de cellules photovoltaïques.

En outre, le procédé peut comporter l'étape suivante :
- synchroniser le mouvement du module de convoyage et le mouvement de l'unité de convoyage de manière à gérer périodiquement la distance entre deux cellules photovoltaïques successives d'une même chaîne de cellules photovoltaïques à former et la distance entre deux chaînes successives de cellules photovoltaïques à former.

Le procédé peut encore comporter les étapes suivantes :
- positionner un premier masque de tir laser au contact des conducteurs de liaison et de l'une de la face avant et de la face arrière de ladite au moins une cellule photovoltaïque avant d'effectuer ledit au moins un tir laser par le biais de la première tête laser de la première unité de soudure laser,
- positionner un deuxième masque de tir laser au contact des conducteurs de liaison et de l'autre de la face avant et de la face arrière de ladite au moins une cellule photovoltaïque avant d'effectuer ledit au moins un tir laser par le biais de la deuxième tête laser de la deuxième unité de soudure laser.

Le procédé peut encore comporter une étape préalable d'utilisation d'une cellule photovoltaïque sacrificielle, ou de type « dummies » en anglais. Cette étape peut consister en la suppression de la première cellule photovoltaïque utilisée dans le procédé, laquelle est sacrifiée. Une telle étape peut être mise en œuvre notamment dans le cas de la fabrication de chaînes complètement interconnectées et séparées en fin de production, par exemple par un système de guillotine.

### BRÈVE DESCRIPTION DES FIGURES

D'autres avantages, buts et caractéristiques particulières de l'invention ressortiront de la description non limitative qui suit d'au moins un mode de mise en œuvre de la présente invention, en regard des figures annexées, sur lesquelles :
- la figure 1 représente, selon une vue en perspective partielle, un exemple de dispositif d'interconnexion par soudure laser de cellules photovoltaïques conforme à l'invention,
- la figure 2 représente une vue de détails du dispositif d'interconnexion de la figure 1 permettant de visualiser la première unité de soudure laser,
- la figure 3 représente une vue de détails du dispositif d'interconnexion de la figure 1 permettant de visualiser la deuxième unité de soudure laser,
- la figure 4 représente une vue de détails du dispositif d'interconnexion de la figure 1 permettant de visualiser la zone de dépose et l'ouverture traversante, et
- la figure 5 illustre le principe de formation d'une chaîne de cellules photovoltaïques au moyen du dispositif d'interconnexion de la figure 1.

Dans l'ensemble de ces figures, des références identiques peuvent désigner des éléments identiques ou analogues.

De plus, les différentes parties représentées sur les figures ne le sont pas nécessairement selon une échelle uniforme, pour rendre les figures plus lisibles.

### DESCRIPTION DÉTAILLÉE DE L'INVENTION

Il est à noter que les termes « vertical » et « horizontal » sont à comprendre ici selon leur sens usuel, et notamment par rapport au positionnement d'une chaîne S de cellules photovoltaïques 4 qui s'étend selon une direction horizontale sur une unité de convoyage 50 du dispositif d'interconnexion par soudure laser 100. De plus, un axe dit « vertical » est orthogonal à un axe dit « horizontal ». En outre, l'expression « mobile en translation selon un axe » peut également signifier ici « mobile en translation parallèlement à un axe ».

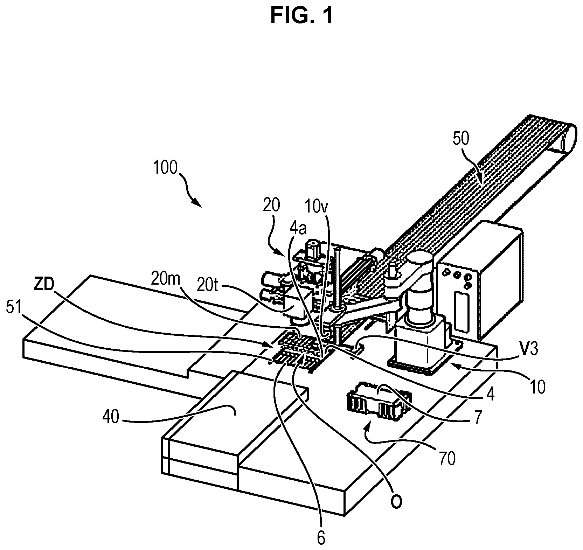

En référence aux figures 1 à 5, on va maintenant décrire un exemple de réalisation d'un dispositif d'interconnexion par soudure laser 100 conforme à l'invention, permettant l'interconnexion de plusieurs cellules photovoltaïques 4 pour former une chaîne S, ou « string » en anglais, par soudure impliquant une fusion locale ou localisée du ou des métaux purs à des températures élevées, notamment supérieures à 600°C, applicable à des cellules photovoltaïques 4 ne résistant pas à des températures trop importantes, notamment supérieures à 200°C. La réussite de cette fusion locale peut notamment dépendre de l'intensité, de la durée et de l'efficacité du tir laser. Elle peut notamment permettre une soudure sur une surface prédéterminée de part et d'autre d'un conducteur de liaison, par exemple une surface de l'ordre de 100 µm x 100 µm.

Le dispositif d'interconnexion 100 permet la soudure laser des conducteurs de liaison 6, typiquement des rubans ou des fils d'interconnexion, au contact de la face avant 4a, et de la face arrière 4b, des cellules photovoltaïques 4 pour former une chaîne S de de cellules photovoltaïques 4.

Comme visible sur la figure 1, le dispositif d'interconnexion 100 comporte une unité d'empilement 70, ou stack, une unité de prise 10, une première unité de soudure laser 20, une deuxième unité de soudure laser 21, une unité de convoyage 50, notamment un convoyeur à bande ou tapis roulant et une unité d'acheminement 40 de conducteurs de liaison 6 vers la première unité de soudure laser 20.

L'unité d'empilement 70, ou stack de cellules photovoltaïques 4, comporte une pluralité de cellules photovoltaïques 4 empilées les unes sur les autres qui sont destinées à être interconnectées par le biais du dispositif d'interconnexion 100 conforme à l'invention.

L'unité de prise 10 correspond ici à un robot de prise permettant la préhension d'une cellule photovoltaïque 4 depuis l'unité d'empilement 70 pour l'acheminer vers une zone de dépose ZD au niveau des première 20 et deuxième 21 unités de soudure laser.

Pour cela, l'unité de prise 10 comporte des moyens de prise de la cellule photovoltaïque 4, ici sous la forme de ventouses V3 pour l'aspiration de la cellule photovoltaïque 4. Les ventouses V3 sont situées à l'extrémité d'un montant vertical portant par un bras robotisé.

De plus, l'unité de prise 10 comporte un troisième système de vision 10v, ici une caméra, qui permet de saisir correctement la cellule photovoltaïque 4 depuis l'unité d'empilement 70 et de la positionner correctement au niveau de la zone de dépose ZD.

La zone de dépose ZD du dispositif d'interconnexion par soudure laser 100 permet la dépose d'une cellule photovoltaïque 4 prise par l'unité de prise 10 au niveau de l'unité d'empilement 70 afin qu'elle puisse être soudée aux conducteurs de liaison 6 sur la face avant 4a et la face arrière 4b.

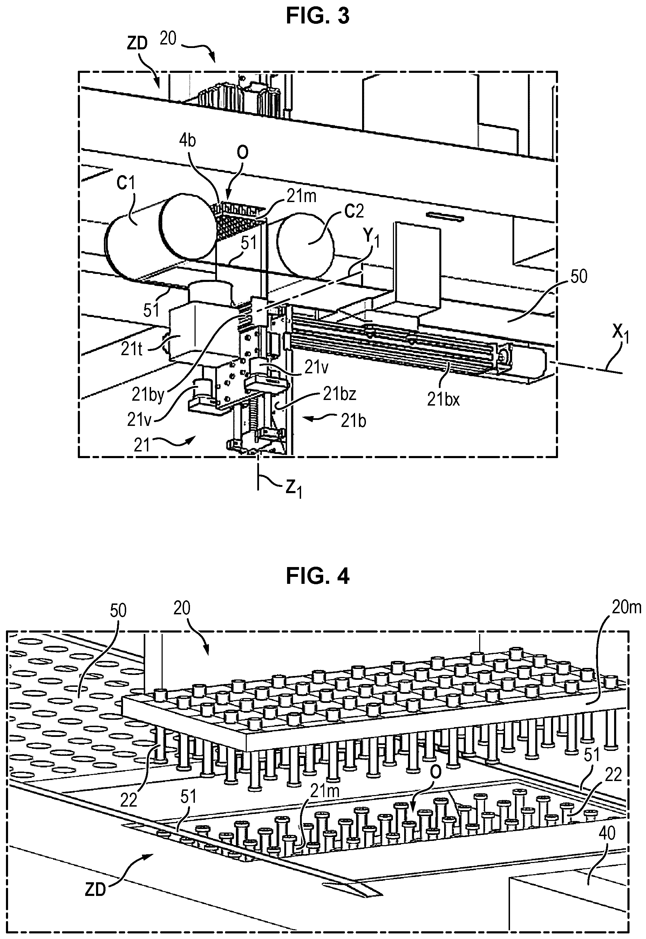

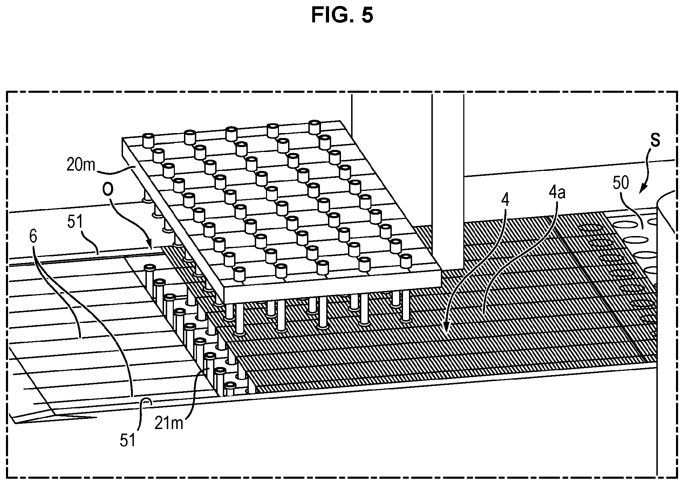

Comme mieux visible sur les figures 4 et 5, la zone de dépose ZD comporte une ouverture traversante O qui permet d'exposer la face avant 4a et la face arrière 4b de la cellule photovoltaïque 4 une fois déposée sur la zone de dépose ZD.

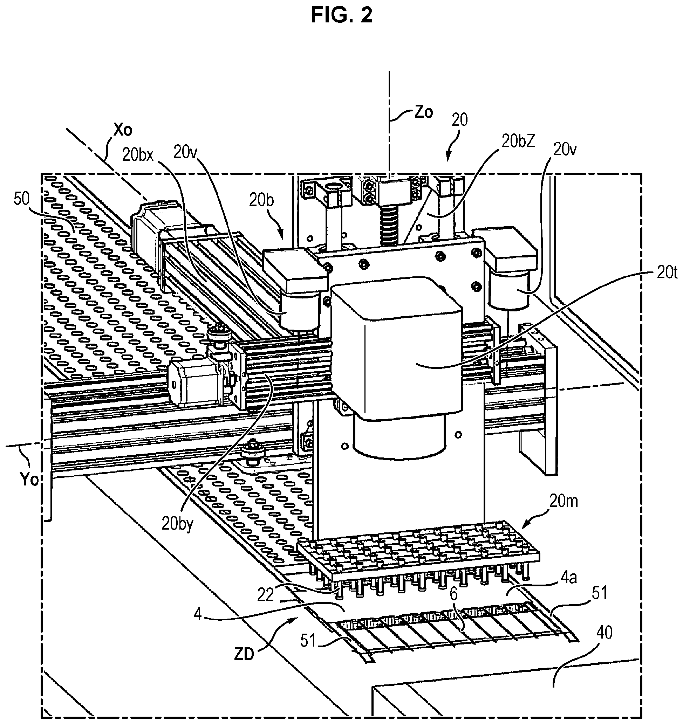

Comme le montre la figure 2 notamment, le dispositif d'interconnexion par soudure laser 100 comporte en outre un module de convoyage 51, ici deux courroies de convoyage 51 positionnées de part et d'autre des bords longitudinaux de l'ouverture traversante O et mises en rotation par le biais d'au moins un premier cylindre C1, visible sur la figure 3. La cellule photovoltaïque 4 est ainsi placée sur les courroies de convoyage 51 par l'unité de prise 10 et donc entraînée par la suite en mouvement de translation horizontal par les courroies de convoyage 51 uniquement au niveau des bords longitudinaux de la cellule photovoltaïque 4, comme visible sur la figure 5.

De plus, le dispositif d'interconnexion par soudure laser 100 comporte une unité de convoyage 50, notamment sous forme de convoyeur à bande ou tapis roulant, qui est située à distance de l'ouverture traversante O, comme le montre la figure 4. Cette unité de convoyage 50 est mise en mouvement par le biais de la rotation d'au moins un deuxième cylindre C2, visible sur la figure 3. L'unité de convoyage 50 est positionnée après l'ouverture traversante O, dans le sens de déplacement des cellules photovoltaïques 4 pour former la chaîne S, de sorte à pouvoir accéder aux deux faces avant 4a et arrière 4b en vue de la soudure des deux côtés. Le transport des cellules photovoltaïques 4 sur l'unité de convoyage 50 est ensuite réalisé par le biais d'orifices d'aspiration présents sur l'unité de convoyage 50 mais également par le biais des deux courroies de convoyage 51 situées de part et d'autre de l'unité de convoyage 50.

Par ailleurs, comme représenté sur la figure 2, la première unité de soudure laser 20 comporte une première tête laser 20t configurée pour effectuer un ou plusieurs tirs laser en direction de la cellule photovoltaïque 4 positionnée dans la zone de dépose ZD. De cette façon, une fusion locale ou localisée des conducteurs de liaison 6 positionnés sur la face avant 4a de la cellule photovoltaïque 4 est réalisée.

Les tirs laser sont réalisés par la première tête laser 20t au travers d'un premier masque de tir laser 20m qui permet à la fois le maintien en position des conducteurs de liaison 6 contre la face avant 4a de la cellule photovoltaïque 4 et, par le biais d'orifices au travers desquels passent les tirs laser, la soudre laser de manière localisée.

De la même façon, comme représenté sur la figure 3, la deuxième unité de soudure laser 21 comporte une deuxième tête laser 21t configurée pour effectuer un ou plusieurs tirs laser en direction de la cellule photovoltaïque 4 positionnée dans la zone de dépose ZD. De cette façon, une fusion locale ou localisée des conducteurs de liaison 6 positionnés sur la face arrière 4b de la cellule photovoltaïque 4 est réalisée.

Les tirs laser sont réalisés par la deuxième tête laser 21t au travers d'un deuxième masque de tir laser 21m qui permet à la fois le maintien en position des conducteurs de liaison 6 contre la face arrière 4b de la cellule photovoltaïque 4 et, par le biais d'orifices au travers desquels passent les tirs laser, la soudre laser de manière localisée.

Chaque masque de tir laser 20m, 21m comporte avantageusement une pluralité de picots de tir laser 22 au travers desquels un tir laser est apte à être effectué pour la soudure par fusion locale ou localisée d'un conducteur de liaison 6 positionné sur la face avant 4a ou la face arrière 4b d'une cellule photovoltaïque 4, chaque picot de tir laser 22 étant creux et comportant une ouverture de forme conique.

Le cas échéant, au moins un masque de tir laser 20m, 21m peut comporter une pluralité de picots aspirants, non représentés, permettant de maintenir les conducteurs de liaison 6 quelle que soit la position de la cellule photovoltaïque 4 dans la chaîne S. Les picots aspirants peuvent permettre, par le biais d'une aspiration à vide, de maintenir les conducteurs de liaison 6, notamment pour la première cellule photovoltaïque en début de production. Les picots aspirants peuvent être disposés en alternance avec les picots de tir laser 22, par exemple sur une rangée ou plusieurs rangées de picots.

En outre, chacune des première 20 et deuxième 21 unités de soudure laser comporte un système de vision permettant de positionner correctement la tête laser 20t, 21t par rapport à la cellule photovoltaïque 4, ici la première unité de soudure laser comporte deux premiers systèmes de vision 20v, de part et d'autre de la première tête laser 20t, comportant chacun une caméra, et la deuxième unité de soudure laser comporte deux deuxièmes systèmes de vision 21v, de part et d'autre de la deuxième tête laser 21t, comportant chacun une caméra également.

Avantageusement, la première tête laser 20t de la première unité de soudure laser 20 est montée en translation selon les trois axes X₀, Y₀, Z₀ d'un repère à trois axes par rapport à un premier bâti 20b de la première unité de soudure laser 20.

De manière symétrique, la deuxième tête laser 21t de la deuxième unité de soudure laser 21 est montée en translation selon les trois axes X₁, Y₁, Z₁ d'un repère à trois axes par rapport à un deuxième bâti 21b de la deuxième unité de soudure laser 21.

En particulier, la première tête laser 20t est mobile en translation selon un premier axe horizontal X₀ par rapport à un premier bâti horizontal 20bx, mobile en translation selon un deuxième axe horizontal Y₀ par rapport à un deuxième bâti horizontal 20by et mobile en translation selon un troisième axe vertical Z₀ par rapport à un troisième bâti vertical 20bz. Des moteurs peuvent être prévus au niveau de extrémités de chacun des premier 20bx, deuxième 20by et troisième 20bz bâtis afin de mettre en mouvement la première tête laser 20t.

De façon analogue, la deuxième tête laser 20t est mobile en translation selon un premier axe horizontal X₁ par rapport à un premier bâti horizontal 21bx, mobile en translation selon un deuxième axe horizontal Y₁ par rapport à un deuxième bâti horizontal 21by et mobile en translation selon un troisième axe vertical Z₁ par rapport à un troisième bâti vertical 21bz. Des moteurs peuvent être prévus au niveau de extrémités de chacun des premier 21bx, deuxième 21by et troisième 21bz bâtis afin de mettre en mouvement la deuxième tête laser 21t.

Le procédé d'interconnexion par soudure laser au moyen du dispositif d'interconnexion par soudure laser 100 décrit précédemment peut alors être mis en œuvre comme décrit ci-après.

Une cellule photovoltaïque 4 est prise au niveau de l'unité d'empilement 70 par l'unité de prise 10, puis acheminée vers la zone de dépose ZD. Précisément, la cellule photovoltaïque 4 est déposée sur des conducteurs de liaison 6 déjà soudés sur la face avant 4a d'une précédente cellule photovoltaïque 4 ayant quitté la zone de dépose ZD en direction de l'unité de convoyage 50. Le dépôt s'effectue avec la face arrière 4b au contact de ces conducteurs de liaison 6, la cellule photovoltaïque 4 étant en appui au niveau de ses côtés sur les courroies de convoyage 51, de part et d'autre de l'ouverture traversante O.

Alors, l'unité d'acheminement 40 permet le positionnement d'autres conducteurs de liaison 6 sur la face avant 4a de la cellule photovoltaïque 4.

La soudure laser peut être réalisée par la première unité de soudure laser 20 sur la face avant 4a de la cellule photovoltaïque 4 et également par la deuxième unité de soudure laser 21 sur la face arrière 4b de la cellule photovoltaïque 4. Les deux soudures laser peuvent être ou non réalisées en même temps. La soudure laser de la deuxième unité de soudure laser 21 peut être réalisée en premier lorsque la cellule photovoltaïque 4 est positionnée sur la zone de dépose ZD, avant ou après le positionnement des conducteurs de liaison 6 issus de l'unité d'acheminement 40 contre la face avant 4a de la cellule photovoltaïque 4.

Une fois que la cellule photovoltaïque 4 est soudée sur ses deux faces avant 4a et arrière 4b, elle peut être convoyée par le biais du module de convoyage 51 vers l'unité de convoyage 50. Les extrémités des conducteurs de liaison 6 présents sur la face avant 4a permettront alors de positionner la face arrière 4b d'une nouvelle cellule photovoltaïque 4 prise depuis l'unité d'empilement 70, ou stack de cellules photovoltaïques 4.

Il est à noter que la soudure laser peut être réalisée par un mouvement de la tête laser 20t, 21t, notamment un mouvement selon les axes X₀, X₁ et Y₀, Y₁ ou bien encore par un changement d'angle du tir laser, au travers du masque de tir laser 20m, 21m.

Le dispositif d'interconnexion par soudure laser 100 comporte avantageusement des moyens d'auto-alignement des cellules photovoltaïques 4 positionnées successivement sur la zone de dépose ZD afin de former la chaîne S de cellules photovoltaïques 4. De plus, le dispositif d'interconnexion par soudure laser 100 comporte des moyens de synchronisation pour effectuer les tirs laser de manière périodique en fonction d'une première distance qui correspond à la somme de la distance entre deux cellules photovoltaïques 4 successives et la taille d'une cellule photovoltaïque 4 et/ou en fonction d'une deuxième distance qui correspond à la somme de la distance entre deux chaînes S successives et la taille d'une cellule photovoltaïque 4. Avantageusement, les chaînes S de cellules photovoltaïques 4 sont ainsi fabriquées de manière automatisée les unes après les autres par le biais d'une synchronisation entre les étapes de soudure laser des faces avant 4a et arrière 4b réalisées par les unités de soudure laser 20, 21, et les étapes de convoyage réalisées par le module de convoyage 51 et l'unité de convoyage 50.

Bien entendu, l'invention n'est pas limitée aux exemples de réalisation qui viennent d'être décrits. Diverses modifications peuvent y être apportées par l'homme du métier.

## Revendications

1. Dispositif d'interconnexion par soudure laser (100) de cellules photovoltaïques (4) pour former au moins une chaîne (S) de cellules photovoltaïques (4) interconnectées par des conducteurs de liaison (6), **caractérisé en ce qu'**il comporte :
- une zone de dépose (ZD) d'au moins une cellule photovoltaïque (4) comprenant une ouverture traversante (O) configurée pour exposer la face avant (4a) et la face arrière (4b) de ladite au moins une cellule photovoltaïque (4) de part et d'autre de l'ouverture traversante (O) lorsque ladite au moins une cellule photovoltaïque (4) est positionnée sur la zone de dépose (ZD),
- une première unité de soudure laser (20) comportant une première tête laser (20t) configurée pour effectuer au moins un tir laser pour la fusion locale d'au moins un conducteur de liaison (6) positionné sur la face avant (4a) de ladite au moins une cellule photovoltaïque (4),
- une deuxième unité de soudure laser (21) comportant une deuxième tête laser (21t) configurée pour effectuer au moins un tir laser pour la fusion locale d'au moins un conducteur de liaison (6) positionné sur la face arrière (4b) de ladite au moins une cellule photovoltaïque (4),
**caractérisé en ce que** les première (20) et deuxième (21) unités de soudure laser sont situées de part et d'autre de l'ouverture traversante (O).

2. Dispositif (100) selon la revendication 1, dans lequel le dispositif d'interconnexion par soudure laser (100) comporte un module de convoyage (51), notamment une courroie de convoyage, de part et d'autre de l'ouverture traversante (O) sur lequel ladite au moins une cellule photovoltaïque (4) est destinée à venir en appui au niveau de ses bords opposés.

3. Dispositif (100) selon la revendication 2, dans lequel le dispositif d'interconnexion par soudure laser (100) comporte une unité de convoyage (50), notamment un convoyeur à bande ou tapis roulant, située à distance de l'ouverture traversante (O), sur laquelle est formée ladite au moins une chaîne (S) de cellules photovoltaïques (4) et sur laquelle ladite au moins une cellule photovoltaïque (4) est destinée à être convoyée par le module de convoyage (51) après soudure laser réalisée sur les faces avant (4a) et arrière (4b) de ladite au moins une cellule photovoltaïque (4), le module de convoyage (51) étant notamment situé de part et d'autre de l'unité de convoyage (50).

4. Dispositif (100) selon l'une des revendications précédentes, dans lequel la première unité de soudure laser (20) comporte un premier masque de tir laser (20m) au travers duquel la première tête laser (20t) est apte à effectuer ledit au moins un tir laser, le premier masque de tir laser (20m) étant configuré pour maintenir en position ledit au moins un conducteur de liaison (6) contre la face avant (4a) de ladite au moins une cellule photovoltaïque (4).

5. Dispositif (100) selon l'une quelconque des revendications précédentes, dans lequel la deuxième unité de soudure laser (21) comporte un deuxième masque de tir laser (21m) au travers duquel la deuxième tête laser (21t) est apte à effectuer ledit au moins un tir laser, le deuxième masque de tir laser (21m) étant configuré pour maintenir en position ledit au moins un conducteur de liaison (6) contre la face arrière (4b) de ladite au moins une cellule photovoltaïque (4).

6. Dispositif (100) selon l'une quelconque des revendications précédentes, dans lequel la première tête laser (20t) de la première unité de soudure laser (20) est montée en translation par rapport à un premier bâti (20b) de la première unité de soudure laser (20), notamment montée en translation selon un premier axe horizontal (X₀), en translation selon un deuxième axe horizontal (Y₀) et en translation selon un troisième axe vertical (Z₀), les premier (X₀), deuxième (Y₀) et troisième (Z₀) axes étant les axes d'un repère à trois axes.

7. Dispositif (100) selon l'une quelconque des revendications précédentes, dans lequel la deuxième tête laser (21t) de la deuxième unité de soudure laser (21) est montée en translation par rapport à un deuxième bâti (21b) de la deuxième unité de soudure laser (21), notamment montée en translation selon un premier axe horizontal (X₁), en translation selon un deuxième axe horizontal (Y₁) et en translation selon un troisième axe vertical (Z₁), les premier (X₁), deuxième (Y₁) et troisième (Z₁) axes étant les axes d'un repère à trois axes.

8. Dispositif (100) selon l'une quelconque des revendications précédentes, dans lequel le dispositif d'interconnexion par soudure laser (100) comporte en outre :
- une unité d'empilement (70) de cellules photovoltaïques (4),
- une unité de prise (10), notamment un robot de prise (10), de ladite au moins une cellule photovoltaïque (4) depuis l'unité d'empilement (70) pour son transport vers la zone de dépose (ZD).

9. Dispositif (100) selon la revendication précédente, dans lequel l'unité de prise (10) comporte des moyens de prise (V3) de ladite au moins une cellule photovoltaïque (4), notamment sous la forme de ventouses (V3) pour l'aspiration de ladite au moins une cellule photovoltaïque (4).

10. Dispositif (100) selon l'une quelconque des revendications précédentes, dans lequel le dispositif d'interconnexion par soudure laser (100) comporte une unité d'acheminement (40) de conducteurs de liaison (6) vers la zone de dépose (ZD).

11. Procédé d'interconnexion par soudure laser de cellules photovoltaïques (4) pour former au moins une chaîne (S) de cellules photovoltaïques (4) interconnectées par des conducteurs de liaison (6), mis en œuvre au moyen d'un dispositif d'interconnexion par soudure laser (100) selon l'une quelconque des revendications précédentes.

12. Procédé selon la revendication 11, dans lequel le procédé comporte les étapes suivantes :
- positionner au moins une cellule photovoltaïque (4) sur la zone de dépose (ZD) en appui de part et d'autre de l'ouverture traversante (O) pour exposer la face avant (4a) et la face arrière (4b) de ladite au moins une cellule photovoltaïque (4), la face avant (4a) et la face arrière (4b) étant au contact d'au moins un conducteur de liaison (6),
- effectuer au moins un tir laser pour la fusion locale dudit au moins un conducteur de liaison (6) positionné sur l'une de la face avant (4a) et de la face arrière (4b) de ladite au moins une cellule photovoltaïque (4) par le biais de la première tête laser (20t) de la première unité de soudure laser (20),
- effectuer au moins un tir laser pour la fusion locale dudit au moins un conducteur de liaison (6) positionné sur l'autre de la face avant (4a) et de la face arrière (4b) de ladite au moins une cellule photovoltaïque (4) par le biais de la deuxième tête laser (21t) de la deuxième unité de soudure laser (21).

13. Procédé selon la revendication 11 ou 12, dans lequel le procédé comporte l'étape suivante :
- déplacer ladite au moins une cellule photovoltaïque (4), après soudure laser, par le biais d'un module de convoyage (51), notamment une courroie de convoyage, situé de part et d'autre de l'ouverture traversante (O) et sur lequel ladite au moins une cellule photovoltaïque (4) est en appui au niveau de ses bords opposés, en direction d'une unité de convoyage (50), notamment un convoyeur à bande ou tapis roulant, située à distance de l'ouverture traversante (O), et sur laquelle est formée ladite au moins une chaîne (S) de cellules photovoltaïques (4).

14. Procédé selon la revendication 13, dans lequel le procédé comporte l'étape suivante :
- synchroniser le mouvement du module de convoyage (51) et le mouvement de l'unité de convoyage (50) de manière à gérer périodiquement la distance entre deux cellules photovoltaïques (4) successives d'une même chaîne (S) de cellules photovoltaïques (4) à former et la distance entre deux chaînes (S) successives de cellules photovoltaïques (4) à former.

15. Procédé selon l'une quelconque des revendications 12 à 14, dans lequel le procédé comporte les étapes suivantes :
- positionner un premier masque de tir laser (20m) au contact des conducteurs de liaison (6) et de l'une de la face avant (4a) et de la face arrière (4b) de ladite au moins une cellule photovoltaïque (4) avant d'effectuer ledit au moins un tir laser par le biais de la première tête laser (20t) de la première unité de soudure laser (20),
- positionner un deuxième masque de tir laser (21m) au contact des conducteurs de liaison (6) et de l'autre de la face avant (4a) et de la face arrière (4b) de ladite au moins une cellule photovoltaïque (4) avant d'effectuer ledit au moins un tir laser par le biais de la deuxième tête laser (21t) de la deuxième unité de soudure laser (21).

## Patentansprüche

1. Vorrichtung zum Zusammenschalten von Photovoltaikzellen (4) durch Laserschweißen (100), um mindestens eine Kette (S) von Photovoltaikzellen (4) zu bilden, die durch Verbindungsleiter (6) zusammengeschaltet sind, **dadurch gekennzeichnet, dass** sie umfasst:
- eine Zone (ZD) zum Ablegen mindestens einer Photovoltaikzelle (4), die eine durchgehende Öffnung (O) umfasst, die dazu konfiguriert ist, die Vorderseite (4a) und die Rückseite (4b) der mindestens einen Photovoltaikzelle (4) auf beiden Seiten der durchgehenden Öffnung (O) freizulegen, wenn die mindestens eine Photovoltaikzelle (4) auf der Ablagezone (ZD) positioniert ist,
- eine erste Laserschweißeinheit (20), die einen ersten Laserkopf (20t) umfasst, der dazu konfiguriert ist, mindestens einen Laserschuss für das lokale Verschmelzen mindestens eines Verbindungsleiters (6), der auf der Vorderseite (4a) der mindestens einen Photovoltaikzelle (4) positioniert ist, auszuführen,
- eine zweite Laserschweißeinheit (21), die eine zweiten Laserkopf (21t) umfasst, der dazu konfiguriert ist, mindestens einen Laserschuss für das lokale Verschmelzen mindestens eines Verbindungsleiters (6), der auf der Rückseite (4b) der mindestens einen Photovoltaikzelle (4) positioniert ist, auszuführen, **dadurch gekennzeichnet, dass** sich die erste (20) und die zweite (21) Laserschweißeinheit auf beiden Seiten der durchgehenden Öffnung (O) befinden.

2. Vorrichtung (100) nach Anspruch 1, wobei die Vorrichtung zum Zusammenschalten durch Laserschweißen (100) ein Fördermodul (51), insbesondere einen Förderriemen, auf beiden Seiten der durchgehenden Öffnung (O) umfasst, an dem die mindestens eine Photovoltaikzelle (4) an ihren gegenüberliegenden Rändern zur Anlage kommen soll.

3. Vorrichtung (100) nach Anspruch 2, wobei die Vorrichtung zum Zusammenschalten durch Laserschweißen (100) eine Fördereinheit (50), insbesondere ein Förderband oder Fließband, das sich in einem Abstand von der durchgehenden Öffnung (O) befindet, umfasst, auf dem die mindestens eine Kette (S) von Photovoltaikzellen (4) gebildet ist, und auf dem die mindestens eine Photovoltaikzelle (4) von dem Fördermodul (51) befördert werden soll, nachdem das Laserschweißen auf der Vorderseite (4a) und der Rückseite (4b) der mindestens einen Photovoltaikzelle (4) durchgeführt wurde, wobei sich das Fördermodul (51) insbesondere auf beiden Seiten der Fördereinheit (50) befindet.

4. Vorrichtung (100) nach einem der vorhergehenden Ansprüche, wobei die erste Laserschweißeinheit (20) eine erste Laserschussmaske (20m) umfasst, durch die hindurch der erste Laserkopf (20t) den mindestens einen Laserschuss ausführen kann, wobei die erste Laserschussmaske (20m) dazu konfiguriert ist, den mindestens einen Verbindungsleiter (6) an der Vorderseite (4a) der mindestens einen Photovoltaikzelle (4) in Position zu halten.

5. Vorrichtung (100) nach einem der vorhergehenden Ansprüche, wobei die zweite Laserschweißeinheit (21) eine zweite Laserschussmaske (21m) umfasst, durch die hindurch der zweite Laserkopf (21t) den mindestens einen Laserschuss ausführen kann, wobei die zweite Laserschussmaske (21m) dazu konfiguriert ist, den mindestens einen Verbindungsleiter (6) an der Rückseite (4b) der mindestens einen Photovoltaikzelle (4) in Position zu halten.

6. Vorrichtung (100) nach einem der vorhergehenden Ansprüche, wobei der erste Laserkopf (20t) der ersten Laserschweißeinheit (20) im Verhältnis zu einem ersten Gestell (20b) der ersten Laserschweißeinheit (20) translationsmäßig montiert ist, insbesondere entlang einer ersten waagerechten Achse (X₀) translationsmäßig montiert ist, entlang einer zweiten waagerechten Achse (Y₀) translationsmäßig montiert ist, und entlang einer dritten senkrechten Achse (Z₀) translationsmäßig montiert ist, wobei die erste (X₀), die zweite (Y₀) und die dritte (Z₀) Achse die Achsen eines dreiachsigen Bezugspunktes sind.

7. Vorrichtung (100) nach einem der vorhergehenden Ansprüche, wobei der zweite Laserkopf (21t) der zweiten Laserschweißeinheit (21) im Verhältnis zu einem zweiten Gestell (21b) der zweiten Laserschweißeinheit (21) translationsmäßig montiert ist, insbesondere entlang einer ersten waagerechten Achse (X₁) translationsmäßig montiert ist, entlang einer zweiten waagerechten Achse (Y₁) translationsmäßig montiert ist. und entlang einer dritten senkrechten Achse (Z₁) translationsmäßig montiert ist, wobei die erste (X₁), die zweite (Y₁) und die dritte (Z₁) Achse die Achsen eines dreiachsigen Bezugspunktes sind.

8. Vorrichtung (100) nach einem der vorhergehenden Ansprüche, wobei die Vorrichtung zum Zusammenschalten durch Laserschweißen (100) ferner umfasst:
- eine Einheit (70) zum Stapeln von Photovoltaikzellen (4),
- eine Einheit (10) zum Ergreifen, insbesondere einen Roboter (10) zum Ergreifen, der mindestens einen Photovoltaikzelle (4) von der Stapeleinheit (70) für ihren Transport zu der Ablagezone (ZD).

9. Vorrichtung (100) gemäß dem vorhergehenden Anspruch, wobei die Greifeinheit (10) Mittel (V3) zum Ergreifen der mindestens einen Photovoltaikzelle (4), insbesondere in Form von Saugnäpfen (V3) zum Ansaugen der mindestens einen Photovoltaikzelle (4), umfasst.

10. Vorrichtung (100) nach einem der vorhergehenden Ansprüche, wobei die Vorrichtung zum Zusammenschalten durch Laserschweißen (100) eine Einheit (40) zum Transportieren von Verbindungsleitern (6) zur Ablagezone (ZD) umfasst.

11. Verfahren zum Zusammenschalten durch Laserschweißen von Photovoltaikzellen (4), um mindestens eine Kette (S) von Photovoltaikzellen (4) zu bilden, die durch Verbindungsleiter (6) zusammengeschaltet sind, das anhand einer Vorrichtung zum Zusammenschalten durch Laserschweißen (100) nach einem der vorhergehenden Ansprüche umgesetzt wird.

12. Verfahren nach Anspruch 11, wobei das Verfahren die folgenden Schritte umfasst:
- Positionieren mindestens einer Photovoltaikzelle (4) auf die Ablagezone (ZD) in beidseitiger Anlage an die durchgehende Öffnung (O), um die Vorderseite (4a) und die Rückseite (4b) der mindestens einen Photovoltaikzelle (4) freizulegen, wobei die Vorderseite (4a) und die Rückseite (4b) mit mindestens einem Verbindungsleiter (6) in Kontakt stehen,
- Ausführen mindestens eines Laserschusses für das lokale Verschmelzen des mindestens einen Verbindungsleiters (6), der auf der einen von der Vorderseite (4a) und der Rückseite (4b) der mindestens eine Photovoltaikzelle (4) positioniert ist, anhand des ersten Laserkopfs (20t) der ersten Laserschweißeinheit (20),
- Ausführen mindestens eines Laserschusses für das lokale Verschmelzen des mindestens einen Verbindungsleiters (6), der auf der anderen von der Vorderseite (4a) und der Rückseite (4b) der mindestens einen Photovoltaikzelle (4) positioniert ist, anhand des zweiten Laserkopfs (21t) der zweiten Laserschweißeinheit (21) .

13. Verfahren nach Anspruch 11 oder 12, wobei das Verfahren den folgenden Schritt umfasst:
- Verschieben der mindestens einen Photovoltaikzelle (4), nach dem Laserschweißen, anhand eines Fördermoduls (51), insbesondere eines Förderriemens, der sich auf beiden Seiten der durchgehenden Öffnung (O) befindet, und auf dem sich die mindestens eine Photovoltaikzelle (4) an ihren gegenüberliegenden Rändern in Anlage befindet, in Richtung auf eine Fördereinheit (50), insbesondere eines Förderbands oder Fließbands, das sich in einem Abstand von der durchgehenden Öffnung (O) befindet, und auf dem die mindestens eine Kette (S) von Photovoltaikzellen (4) positioniert ist.

14. Verfahren nach Anspruch 13, wobei das Verfahren den folgenden Schritt umfasst:
- Synchronisieren der Bewegung des Fördermoduls (51) und der Bewegung der Fördereinheit (50), um periodisch den Abstand zwischen zwei aufeinanderfolgenden Photovoltaikzellen (4) derselben Kette (S) von zu bildenden Photovoltaikzellen (4) und den Abstand zwischen zwei aufeinanderfolgenden Ketten (S) von zu bildenden Photovoltaikzellen (4) zu handhaben.

15. Verfahren nach einem der Ansprüche 12 bis 14, wobei das Verfahren die folgenden Schritte umfasst:
- Positionieren einer ersten Laserschussmaske (20m) in Kontakt mit den Verbindungsleitern (6) und der einen von der Vorderseite (4a) und der Rückseite (4b) der mindestens einen Photovoltaikzelle (4) vor dem Ausführen des mindestens einen Laserschusses anhand des ersten Laserkopfs (20t) der ersten Laserschweißeinheit (20),
- Positionieren einer zweiten Laserschussmaske (21m) in Kontakt mit den Verbindungsleitern (6) und der anderen von der Vorderseite (4a) und der Rückseite (4b) der mindestens einen Photovoltaikzelle (4) vor dem Ausführen des mindestens einen Laserschusses anhand des zweiten Laserkopfs (21t) der zweiten Laserschweißeinheit (21).

## Claims

1. A laser-welding interconnection device (100) for photovoltaic cells (4) to form at least one string (S) of photovoltaic cells (4) interconnected by connecting conductors (6), **characterised in that** it comprises:
- a placement area (ZD) for at least one photovoltaic cell (4) comprising a through-hole (0) configured to expose the front face (4a) and the rear face (4b) of said at least one photovoltaic cell (4) on either side of the through-opening (0) when said at least one photovoltaic cell (4) is positioned on the placement area (ZD),
- a first laser welding unit (20) comprising a first laser head (20t) configured to perform at least one laser pulse for the local melting of at least one connecting conductor (6) positioned on the front face (4a) of said at least one photovoltaic cell (4),
- a second laser welding unit (21) comprising a second laser head (21t) configured to perform at least one laser pulse to locally melt at least one connecting conductor (6) positioned on the rear face (4b) of said at least one photovoltaic cell (4),
**characterised in that** the first (20) and second (21) laser welding units are situated on either side of the through-hole (0).

2. A device (100) according to claim 1, wherein the laser-welding interconnection device (100) comprises a conveying module (51), in particular a conveyor belt, on either side of the through-hole (0), on which the at least one photovoltaic cell (4) is intended to rest at its opposite edges.

3. A device (100) according to claim 2, wherein the laser-welding interconnection device (100) comprises a conveying unit (50), in particular a belt conveyor or roller conveyor, situated at a distance from the through-opening (0), on which the at least one string (S) of photovoltaic cells (4) is formed and on which the at least one photovoltaic cell (4) is intended to be conveyed by the conveying module (51) after laser welding has been carried out on the front (4a) and rear (4b) faces of the at least one photovoltaic cell (4), the conveying module (51) being situated, in particular, on either side of the conveying unit (50).

4. A device (100) according to one of the preceding claims, in which the first laser welding unit (20) comprises a first laser firing mask (20m) through which the first laser head (20t) is capable of performing said at least one laser firing, the first laser firing mask (20m) being configured to hold said at least one connecting conductor (6) in position against the front face (4a) of said at least one photovoltaic cell (4).

5. A device (100) according to any one of the preceding claims, wherein the second laser welding unit (21) comprises a second laser firing mask (21m) through which the second laser head (21t) is capable of performing said at least one laser firing, the second laser firing mask (21m) being configured to hold said at least one connecting conductor (6) in position against the rear face (4b) of said at least one photovoltaic cell (4).

6. A device (100) according to any one of the preceding claims, wherein the first laser head (20t) of the first laser welding unit (20) is mounted so as to be capable of translational movement relative to a first frame (20b) of the first laser welding unit (20), in particular mounted so as to be capable of translation along a first horizontal axis (X₀ ), translation along a second horizontal axis (Y₀ ) and translation along a third vertical axis (Z₀ ), the first (X₀ ), second (Y₀ ) and third (Z₀ ) axes being the axes of a three-axis coordinate system.

7. A device (100) according to any one of the preceding claims, in which the second laser head (21t) of the second laser welding unit (21) is mounted so as to be capable of translational movement relative to a second frame (21b) of the second laser welding unit (21), in particular so as to be capable of translational movement along a first horizontal axis (X₁ ), along a second horizontal axis (Y₁ ) and along a third vertical axis (Z₁ ), the first (X₁ ), second (Y₁ ) and third (Z₁ ) axes being the axes of a three-axis coordinate system.

8. A device (100) according to any one of the preceding claims, wherein the laser-welding interconnection device (100) further comprises:
- a stacking unit (70) for photovoltaic cells (4),
- a picking unit (10), in particular a robotic pick-and-place unit (10), for picking up said at least one photovoltaic cell (4) from the stacking unit (70) for transport to the placement zone (ZD).

9. A device (100) according to the preceding claim, wherein the gripping unit (10) comprises gripping means (V3) for gripping said at least one photovoltaic cell (4), in particular in the form of suction cups (V3) for suctioning said at least one photovoltaic cell (4).

10. A device (100) according to any one of the preceding claims, wherein the laser-welding interconnection device (100) comprises a unit (40) for conveying connecting conductors (6) to the placement zone (ZD).

11. A method for laser-welding photovoltaic cells (4) to form at least one string (S) of photovoltaic cells (4) interconnected by connecting conductors (6), carried out by means of a laser-welding interconnection device (100) according to any one of the preceding claims.

12. A method according to claim 11, wherein the method comprises the following steps:
- positioning at least one photovoltaic cell (4) on the placement area (ZD) so that it rests on either side of the through-hole (0) to expose the front face (4a) and the rear face (4b) of said at least one photovoltaic cell (4), the front face (4a) and the rear face (4b) being in contact with at least one connecting conductor (6),
- performing at least one laser pulse to locally fuse said at least one connecting conductor (6) positioned on either the front face (4a) or the rear face (4b) of said at least one photovoltaic cell (4) by means of the first laser head (20t) of the first laser welding unit (20),
- performing at least one laser pulse to locally melt said at least one connecting conductor (6) positioned on the other of the front face (4a) and the rear face (4b) of said at least one photovoltaic cell (4) by means of the second laser head (21t) of the second laser welding unit (21).

13. A method according to claim 11 or 12, wherein the method comprises the following step:
- moving said at least one photovoltaic cell (4), after laser welding, by means of a conveying module (51), in particular a conveyor belt, situated on either side of the through-opening (O) and on which said at least one photovoltaic cell (4) rests at its opposite edges, in the direction of a conveying unit (50), in particular a belt conveyor or conveyor belt, situated at a distance from the through-opening (0), and on which the at least one chain (S) of photovoltaic cells (4) is formed.

14. A method according to claim 13, wherein the method comprises the following step:
- synchronising the movement of the conveying module (51) and the movement of the conveying unit (50) so as to periodically control the distance between two successive photovoltaic cells (4) of the same chain (S) of photovoltaic cells (4) to be formed and the distance between two successive chains (S) of photovoltaic cells (4) to be formed.

15. A method according to any one of claims 12 to 14, wherein the method comprises the following steps:
- positioning a first laser firing mask (20m) in contact with the connecting conductors (6) and with either the front face (4a) or the rear face (4b) of said at least one photovoltaic cell (4) before performing said at least one laser firing by means of the first laser head (20t) of the first laser welding unit (20),
- positioning a second laser firing mask (21m) in contact with the connecting conductors (6) and the other of the front face (4a) and the rear face (4b) of said at least one photovoltaic cell (4) before performing said at least one laser firing via the second laser head (21t) of the second laser welding unit (21).
